(19) Europäisches Patentamt
European Patent Office
Office européen des brevets

(11) **EP 4 660 708 A1**

(12) **EUROPEAN PATENT APPLICATION**
published in accordance with Art. 153(4) EPC

(43) Date of publication:
**10.12.2025 Bulletin 2025/50**

(21) Application number: **23919980.5**

(22) Date of filing: **20.12.2023**

(51) International Patent Classification (IPC):
**G03F 7/20** (2006.01)

(52) Cooperative Patent Classification (CPC):
**G03F 7/20; H05G 2/00**

(86) International application number:
**PCT/JP2023/045822**

(87) International publication number:
**WO 2024/161845 (08.08.2024 Gazette 2024/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **03.02.2023 JP 2023015043**

(71) Applicant: **Lasertec Corporation
Yokohama-shi, Kanagawa 222-8552 (JP)**

(72) Inventor: **TAJIMA, Atsushi
Yokohama-shi, Kanagawa 222-8552 (JP)**

(74) Representative: **Pfenning, Meinig & Partner mbB
Patent- und Rechtsanwälte
Theresienhöhe 11a
80339 München (DE)**

(54) **LIGHT SOURCE DEVICE**

(57)    A light source device capable of inhibiting surface vibrations of molten metal and making a distribution of intensity of illumination light uniform is provided. A light source device (1) according to the present disclosure includes: a vessel (10) having a rotation axis R and including a cylindrical side wall (15) that rotates about the rotation axis R; molten metal (20) that touches at least a part of an inner surface (30) of the side wall (15); and a processed part (40) including at least one of a convex part (41) and a concave part (42) formed in the part, in which the molten metal (20) irradiated by laser light LR generates light including EUV light.

Fig. 1

## Description

### Technical Field

The present disclosure relates to a light source device.

### Background Art

Patent Literature 1 discloses an EUV light source that includes a rotatable, cylindrically-symmetric element having a surface coated with a plasma-forming target material to generate EUV light via formation of a plasma by excitation of the target material. The EUV light source disclosed in Patent Literature 1 fixes the target material by fitting a convex part of the target material into a concave part formed on the surface of the cylindrically-symmetric element.

Patent Literature 2 discloses an EUV light source including a target unit arranged to present a target surface to a plasma-forming material and a laser unit arranged to irradiate the target surface with radiation beams to form a plasma. The EUV light source disclosed in Patent Literature 2 includes toothed convex parts provided on a surface of a wheel to which the plasma-forming material is attached.

Patent Literature 3 and 4 each disclose an EUV light source that includes a disc-like rotating element and a reserving vessel that is disposed inside a cover-like structure and reserves a liquid high temperature plasma raw material, in which a part of the rotating element is immersed in the high temperature plasma raw material. The EUV light source disclosed in Patent Literature 3 controls a film thickness of the high temperature plasma raw material attached onto a surface of the rotating element. The EUV light source disclosed in Patent Literature 4 includes concave and convex parts for allowing the high temperature plasma raw material to be attached onto the surface of the rotating element.

### Citation List

### Patent Literature

[Patent Literature 1] Japanese Unexamined Patent Application Publication No. 2020-077007
[Patent Literature 2] Published Japanese Translation of PCT International Publication for Patent Application, No. 2015-505418
[Patent Literature 3] Japanese Unexamined Patent Application Publication No. 2014-216286
[Patent Literature 4] Japanese Unexamined Patent Application Publication No. 2014-089880

### Summary of Invention

One of methods for generating EUV light is a method for putting a liquid molten metal into a vessel such as a crucible to generate EUV light from a plasma generated by irradiating the molten metal with laser light. When this method is used, surface vibrations of the molten metal may cause misalignment of an emission point of the EUV light. In this case, the uniformity of distribution of the intensity of the EUV light, which serves as illumination light, is reduced.

The present disclosure has been made in order to solve the aforementioned problem, and an object of the present disclosure is to provide a light source device capable of inhibiting surface vibrations of molten metal and making a distribution of intensity of illumination light uniform.

A light source device according to the present disclosure includes: a vessel having a rotation axis and including a cylindrical side wall that rotates about the rotation axis; molten metal that touches at least a part of an inner surface of the side wall; and a processed part including at least one of a convex part and a concave part formed in the part, in which the molten metal irradiated by laser light generates light including EUV light.

In the above light source device, the inner surface may include a part concave in a direction away from the rotation axis, and the processed part may be formed in the concave part.

In the above light source device, the inner surface may include a cylindrical first inner peripheral surface, a cylindrical second inner peripheral surface, and a cylindrical third inner peripheral surface in this order from one end side to another end side along a direction of the rotation axis, and when a distance from the rotation axis to the inner surface is defined as a radius, the second inner peripheral surface may include a part having the radius greater than the radius of the first inner peripheral surface, and the processed part may be formed on the second inner peripheral surface.

In the above light source device, the second inner peripheral surface may include a part having the radius greater than the radius of the third inner peripheral surface, and the molten metal may be located between one end of the second inner peripheral surface and another end of the second inner peripheral surface.

In the above light source device, the processed part may extend in a direction of the rotation axis.

In the above light source device, a plurality of the processed parts may be formed in the part, and the plurality of processed parts may be disposed at equal intervals in a rotation direction of the rotation axis.

In the above light source device, the processed part may include the convex part and the concave part formed so as to be adjacent to the convex part.

In the above light source device, the processed part may include a punch mark.

In the above light source device, the processed part may include a plurality of the convex parts, a plurality of the concave parts, and a rough surface area including one of the plurality of convex parts or the plurality of concave parts, and the inner surface may include the rough surface area and a smooth surface area having a surface roughness smaller than a surface roughness of the rough surface area.

In the above light source device, the processed part may include a plurality of the convex parts, a plurality of the concave parts, and a rough surface area including one of the plurality of convex parts or the plurality of concave parts, the second inner peripheral surface may include the rough surface area, and at least one of the first inner peripheral surface and the third inner peripheral surface may include a smooth surface area having a surface roughness smaller than a surface roughness of the rough surface area.

According to the present disclosure, it is possible to provide a light source device capable of inhibiting surface vibrations of molten metal and making a distribution of intensity of illumination light uniform.

## Brief Description of Drawings

Fig. 1 is a cross-sectional view illustrating a light source device according to a first embodiment;

Fig. 2 is a cross-sectional view illustrating a vessel of the light source device according to the first embodiment;

Fig. 3 is a cross-sectional view illustrating a side wall of the vessel of the light source device according to the first embodiment;

Fig. 4 is a schematic view illustrating an inner surface of the vessel of the light source device according to the first embodiment;

Fig. 5 is a cross-sectional view illustrating a side wall of the vessel of the light source device according to the first embodiment, and shows an enlarged view of an area V shown in Fig. 7;

Fig. 6 is a cross-sectional view illustrating a side wall of the vessel of the light source device according to the first embodiment, and shows an enlarged view of the area V shown in Fig. 7;

Fig. 7 is a cross-sectional view illustrating the vessel of the light source device according to the first embodiment;

Fig. 8 is a cross-sectional view illustrating a side wall of a vessel of a light source device according to Modified Example 1 of the first embodiment;

Fig. 9 is a cross-sectional view illustrating a side wall of a vessel of a light source device according to Modified Example 2 of the first embodiment;

Fig. 10 is a graph illustrating behavior of surface vibrations of molten metal in a light source device according to a comparative example, and shows a displacement of a surface of molten metal with respect to time;

Fig. 11 is a graph illustrating behavior of surface vibrations of molten metal in the light source device according to the comparative example, and shows a peak-to-peak magnitude of the surface of the molten metal with respect to time;

Fig. 12 is a graph illustrating behavior of surface vibrations of molten metal in the light source device according to the comparative example, and shows a vibration frequency on the surface of the molten metal with respect to time;

Fig. 13 is a graph illustrating behavior of surface vibrations of molten metal in the light source device according to the first embodiment, and shows a displacement of the surface of the molten metal with respect to time;

Fig. 14 is a graph illustrating behavior of surface vibrations of molten metal in the light source device according to the first embodiment, and shows a peak-to-peak magnitude of a surface of molten metal with respect to time;

Fig. 15 is a graph illustrating behavior of surface vibrations of molten metal in the light source device according to the first embodiment, and shows a vibration frequency on the surface of the molten metal with respect to time;

Fig. 16 is a diagram illustrating an image obtained by detecting, by a detector, EUV light generated by the light source device according to the comparative example;

Fig. 17 is a diagram illustrating surface vibrations of the molten metal in the vessel of the light source device;

Fig. 18 is a diagram illustrating an image obtained by detecting, by a detector, the EUV light generated by the light source device according to the first embodiment;

Fig. 19 is a diagram illustrating an image obtained by detecting, by a detector, the EUV light generated by the light source device according to the first embodiment;

Fig. 20 is a graph illustrating a position of the surface of molten metal in the vessel in the light source device according to the first embodiment, in which the horizontal axis indicates time and the vertical axis indicates the position of the surface of the molten metal;

Fig. 21 is a graph illustrating a position of the surface of molten metal in the vessel in the light source device according to the comparative example, in which the horizontal axis indicates time and the vertical axis indicates the position of the surface of the molten metal;

Fig. 22 is a graph illustrating a position of the surface of molten metal in the vessel in the light source device according to the first embodiment, in which the horizontal axis indicates time and the vertical axis indicates the position of the surface of the molten metal;

Fig. 23 is a schematic view illustrating an inner surface of a vessel of a light source device according to a second embodiment; and

Fig. 24 is a schematic view illustrating the inner surface of the vessel of the light source device according to the second embodiment.

**Description of Embodiments**

A specific structure of the present embodiments will be described hereinbelow with reference to the drawings. The description provided hereinbelow merely illustrates preferred embodiments of the present disclosure, and the scope of the present disclosure is not limited to the below-described embodiments. In the following description, the identical reference symbols denote substantially identical elements.

(First Embodiment)

A light source device according to a first embodiment will be described. A light source device according to this embodiment puts molten metal into a vessel such as a crucible and rotates this vessel to generate EUV light from a plasma generated by irradiating the molten metal with laser light. The light source device includes a processed part such as a convex part or a protrusion on an inner surface of a side wall of the vessel that is rotated. Such a processed part functions as a breakwater that dissipates surface waves of the molten metal, like a tetrapod on a beach. Accordingly, the light source device according to this embodiment can inhibit surface vibrations of the molten metal and reduce misalignment of an emission point of EUV light. Hereinafter, with reference to the drawings, the light source device will be described in the following items <Outline of Light Source Device>, <Inner surface of Vessel>, and <Processed Part>.

<Outline of Light Source Device>

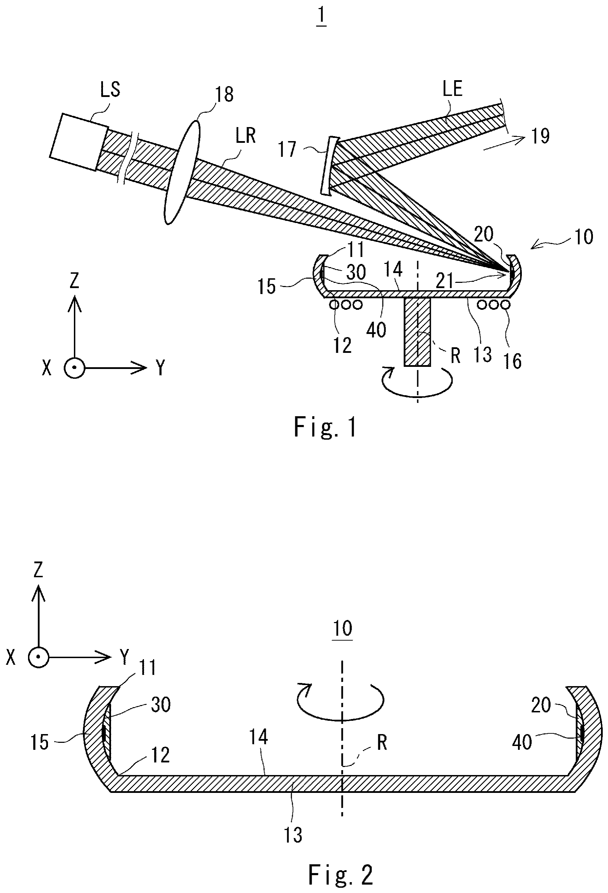

Fig. 1 is a cross-sectional view illustrating the light source device according to the first embodiment. As shown in Fig. 1, a light source device 1 includes a vessel 10. The light source device 1 may further include molten metal 20 and a processed part 40. The vessel 10 is, for example, a crucible, and metal can be melt therein. The vessel 10 holds the molten metal 20, which is a target for generating a plasma 21 by irradiation of laser light LR. Thus, the molten metal 20 is held in the vessel 10. The molten metal 20 is, for example, molten indium-tin alloy (InSn). The molten metal 20 is not limited to InSn as long as the plasma is generated by the irradiation of the laser light LR, and may be molten tin (Sn), molten lithium (Li), or the like.

The vessel 10, which has a rotation axis R, rotates about the rotation axis centered on the rotation axis R. For the convenience of description of the light source device 1, the XYZ-orthogonal coordinate axis system is used. The direction in which the rotation axis R extends is referred to as a Z-axis direction. The direction perpendicular to the Z-axis direction is referred to as an X-axis direction, and the direction perpendicular to the X-axis direction and the Z-axis direction is referred to as a Y-axis direction. The +Z-axis direction is called upward and the -Z-axis direction is called downward for the convenience of description. The terms upward (or up) and downward (or bottom) indicate directions used for the convenience of description, and do not indicate the direction in which the light source device 1 is actually disposed.

The vessel 10 has, for example, a cylindrical shape in which an upper end 11 is opened. A lower end 12 of the vessel 10 may be closed. A closed part of the vessel 10 is called a bottom part 13. The inner surface of the bottom part 13 is denoted by a bottom surface 14. The vessel 10 includes a cylindrical side wall 15. Therefore, the vessel 10 includes a cylindrical side wall 15 that rotates about the rotation axis R. An inner surface 30 of the side wall 15 is formed to surround the rotation axis R. The inner surface 30 has, for example, a cylindrical shape. The inner surface 30 includes one end and another end in the direction of the rotation axis R. An upper end of the inner surface 30 is the upper end 11, and a lower end of the inner surface 30 is the lower end 12. The processed part 40 is formed on the inner surface 30.

The light source device 1 may include, besides the vessel 10, a heater 16 and a collector mirror 17. Due to heating by the heater 16, the molten metal 20 can be formed in the vessel 10. The collector mirror 17 reflects the generated EUV light LE. The EUV light LE is generated from the plasma 21 generated by the laser light LR irradiated onto the molten metal 20.

The light source device 1 may include an excitation laser LS that generates laser light LR, or may use laser light LR from an excitation laser LS installed outside the light source device 1. The laser light LR is collected by the lens 18 and is irradiated onto the molten metal 20. The laser light LR is, for example, IR laser light. The molten metal 20 irradiated by the laser light LR generates light including EUV light LE. The EUV light LE generated from the molten metal 20 is emitted to an optical device such as an inspection device 19 as illumination light.

<Inner Surface of Vessel>

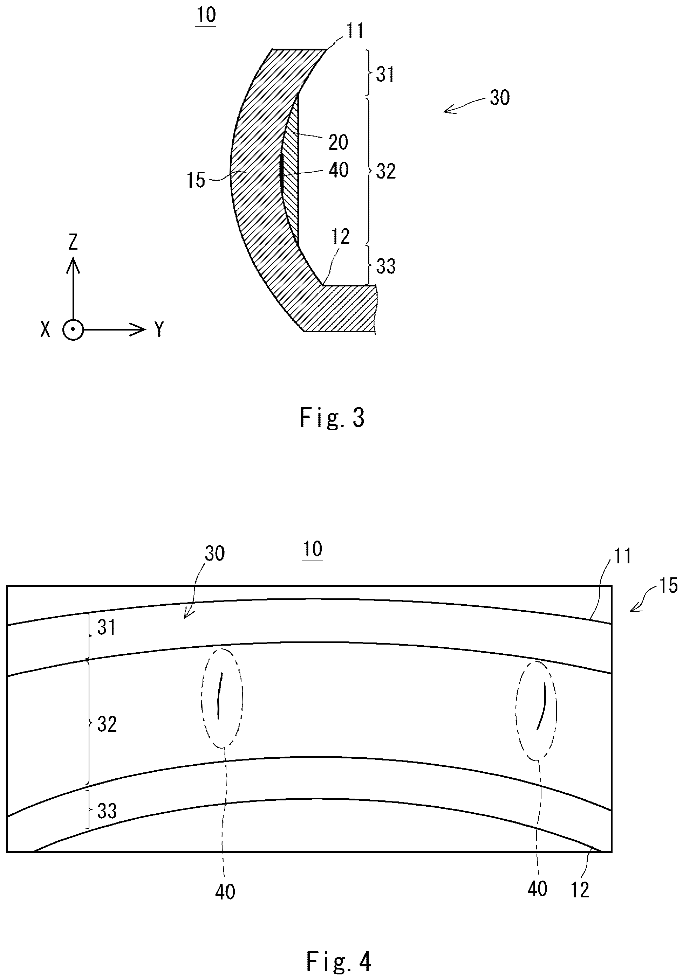

Fig. 2 is a cross-sectional view illustrating the vessel 10 of the light source device 1 according to the first embodiment. Fig. 3 is a cross-sectional view illustrating the side wall 15 of the vessel 10 of the light source device 1 according to the first embodiment. Fig. 4 is a schematic view illustrating the inner surface 30 of the vessel 10 of the light source device 1 according to the first embodiment.

As shown in Figs. 2-4, the cross section of the inner surface 30 taken by a plane including the rotation axis R has a concave part. That is, the inner surface 30 includes a part concave in a direction away from the rotation axis R. Therefore, the center part of the inner surface 30 is concave relative to the upper part and the lower part thereof. The inner surface 30 of the side wall 15 includes a cylindrical first inner peripheral surface 31, a cylindrical second inner peripheral surface 32, and a cylindrical third inner peripheral surface 33 in this order from the upper end 11 to the lower end 12 along the direction of the rotation axis R. The upper end of the first inner peripheral surface 31 may coincide with the upper end 11 of the inner surface 30. The lower end of the first inner peripheral surface 31 may coincide with the upper end of the second inner peripheral surface 32. The lower end of the second inner peripheral surface 32 may coincide with the upper end of the third inner peripheral surface 33. The lower end of the third inner peripheral surface 33 may coincide with the lower end 12 of the inner surface 30.

When the distance from the rotation axis R to the inner surface 30 of the side wall 15 is defined as a radius, the second inner peripheral surface 32 includes a part having a radius which is greater than a radius of the first inner peripheral surface 31. For example, the radius of any part of the second inner peripheral surface 32 is greater than the radius of any part of the first inner peripheral surface 31. Further, the second inner peripheral surface 32 includes a part having a radius which is greater than a radius of the third inner peripheral surface 33. For example, the radius of any part of the second inner peripheral surface 32 is greater than the radius of any part of the third inner peripheral surface 33.

The molten metal 20 touches at least a part of the inner surface 30 of the side wall 15 in the vessel 10. When the vessel 10 rotates about the rotation axis R, the molten metal 20 collects in the concave part of the inner surface 30 due to a centrifugal force. For example, the molten metal 20 collects on the second inner peripheral surface 32. Therefore, the molten metal 20 touches the second inner peripheral surface 32. On the inner surface 30 of the side wall 15, the second inner peripheral surface 32 is a part that the molten metal 20 touches. The first inner peripheral surface 31 is a part that the molten metal 20 does not touch. The third inner peripheral surface 33 is a part that the molten metal 20 does not touch. Therefore, the molten metal 20 is located between the upper end of the second inner peripheral surface 32 and the lower end thereof. The laser light LR is irradiated onto the molten metal 20 located on the second inner peripheral surface 32.

<Processed Part>

The processed part 40 is formed in at least a part of the inner surface 30. For example, the processed part 40 is formed in a part of the inner surface 30 that the molten metal 20 touches. Specifically, the processed part 40 is formed in a concave part. The processed part 40 may be formed on the second inner peripheral surface 32. The processed part 40 may not be formed on the first inner peripheral surface 31 and the third inner peripheral surface 33. Therefore, the processed part 40 is located between the upper end and the lower end of the second inner peripheral surface 32. Note that the processed part 40 may be formed on each of the first inner peripheral surface 31 and the third inner peripheral surface 33.

The processed part 40 may include a punch mark formed by pressing a punch. In this case, there is no need to add any new material when the processed part 40 is formed, whereby it is possible to maintain the weight balance of the vessel 10. The processed part 40 may be an aggregation of punch marks. Note that the processed part 40 is not limited to punch marks as long as it protrudes from the inner surface 30, and it may also be the one in which a fine member is bonded to the inner surface 30 in a convex shape by thermal spraying or the like. The processed part 40 may have a shape extending in the direction of the rotation axis R. That is, the processed part 40 may have a shape extending in the direction perpendicular to a rotation direction of the rotation axis R. By employing such a shape, surface vibrations of the molten metal 20 can be efficiently inhibited.

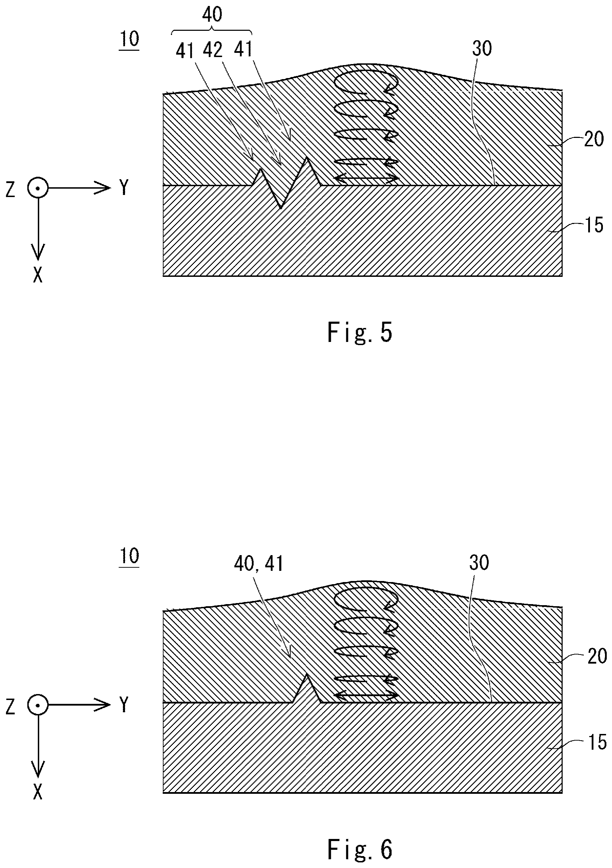

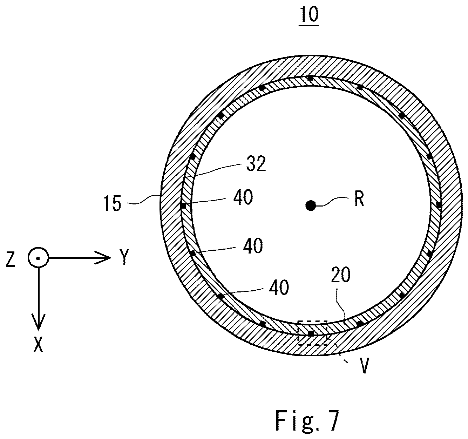

Figs. 5 and 6 are cross-sectional views illustrating the side wall 15 of the vessel 10 of the light source device 1 according to the first embodiment, and each show an enlarged view of an area V in Fig. 7. As shown in Fig. 5, the processed part 40 may include convex parts 41 and a concave part 42 formed to be adjacent to the convex parts 41. For example, when the processed part 40 includes a punch mark, the processed part 40 may include a plurality of convex parts 41 formed so as to hold the concave part 42 therebetween. By employing such a shape, surface vibrations of the molten metal 20 can be efficiently inhibited. Alternatively, as shown in Fig. 6, the processed part 40 may include only a convex part 41.

Even with such a configuration, surface vibrations of the molten metal 20 can be inhibited.

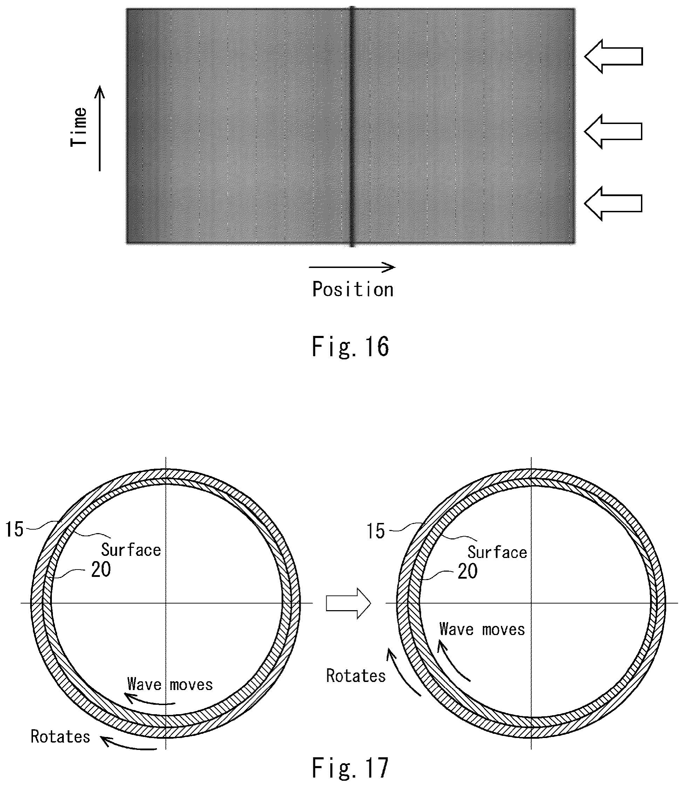

Fig. 7 is a cross-sectional view illustrating the vessel 10 of the light source device 1 according to the first embodiment. As shown in Fig. 7, a plurality of processed parts 40 may be formed on the second inner peripheral surface 32. Note that some reference symbols are omitted in order to prevent the figure from being complicated. Some reference symbols may be omitted in other drawings as well. The plurality of processed parts 40 may be disposed at equal intervals in the rotation direction of the rotation axis R. By employing this arrangement, surface vibrations of the molten metal 20 can be further inhibited. It is also possible to improve the balance of the rotation of the vessel 10. In Fig. 7, 16 processed parts 40 are disposed on the second inner peripheral surface 32 at equal intervals. It is sufficient that at least one processed part 40 be formed on the inner surface 30 of the side wall 15, and the number of processed parts 40 formed on the inner surface 30 is not limited.

(Modified Example 1)

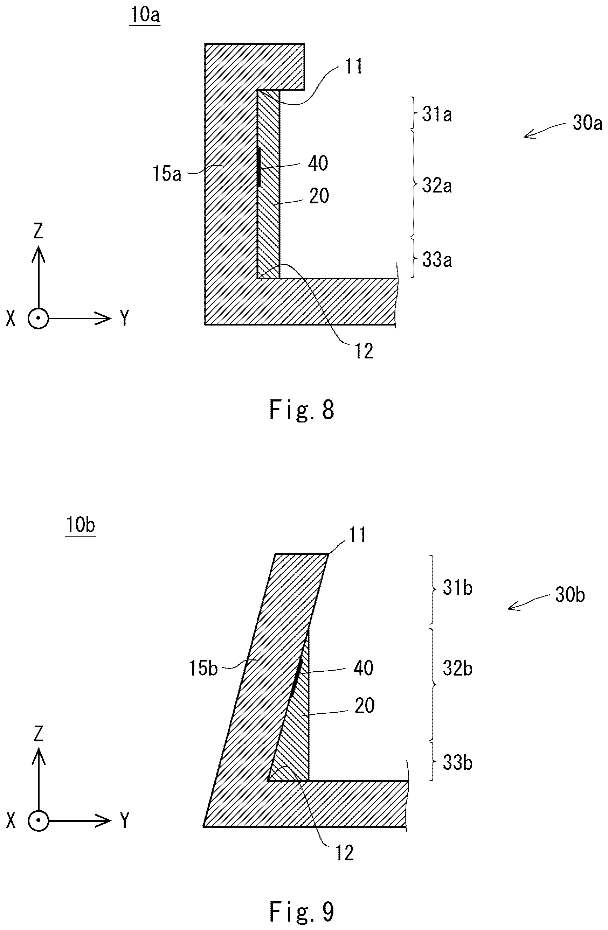

Fig. 8 is a cross-sectional view illustrating a side wall 15a of a vessel 10a of a light source device 1 according to Modified Example 1 of the first embodiment. As shown in Fig. 8, in the vessel 10a according to Modified Example 1, an inner surface 30a formed so as to surround a rotation axis R may include a cylindrical part with a constant distance from the rotation axis R. The inner surface 30a of the side wall 15a includes a cylindrical first inner peripheral surface 31a, a cylindrical second inner peripheral surface 32a, and a cylindrical third inner peripheral surface 33a in this order from an upper end 11 to a lower end 12 along a direction of the rotation axis R. In this example, when a distance from the rotation axis R to the inner surface 30a of the side wall 15a is defined as a radius, the radius of the first inner peripheral surface 31a, the radius of the second inner peripheral surface 32a, and the radius of the third inner peripheral surface 33a have the same size. Here, "the same size" does not necessarily mean that they are exactly the same size, and it is sufficient that they have the same size within a range that includes some measurement error.

When the vessel 10a rotates about the rotation axis R, the molten metal 20 spreads to the first inner peripheral surface 31a, the second inner peripheral surface 32a, and the third inner peripheral surface 33a due to a centrifugal force. Then, the molten metal 20 touches the first inner peripheral surface 31a, the second inner peripheral surface 32a, and the third inner peripheral surface 33a. In the inner surface 30a, the first inner peripheral surface 31a, the second inner peripheral surface 32a, and the third inner peripheral surface 33a are parts that the molten metal 20 touches. Therefore, the molten metal 20 is located between an upper end of the first inner peripheral surface 31a and a lower end of the third inner peripheral surface 33a.

A processed part 40 is formed on the second inner peripheral surface 32a. The processed part 40 may be formed on each of the first inner peripheral surface 31a and the third inner peripheral surface 33a. Therefore, the processed part 40 may be located between an upper end of the second inner peripheral surface 32a and a lower end of the second inner peripheral surface 32a, or between the upper end of the first inner peripheral surface 31a and the lower end of the third inner peripheral surface 33a.

(Modified Example 2)

Fig. 9 is a cross-sectional view illustrating a side wall 15b of a vessel 10b of a light source device 1 according to Modified Example 2 of the first embodiment. As shown in Fig. 9, in the vessel 10b according to Modified Example 2, an inner surface 30b formed so as to surround a rotation axis R may include a shape that widens outward toward the bottom. In the vessel 10b, the inner surface 30b of the side wall 15b includes a cylindrical first inner peripheral surface 31b, a cylindrical second inner peripheral surface 32b, and a cylindrical third inner peripheral surface 33b in this order from an upper end 11 to a lower end 12 along a direction of the rotation axis R. In this example, when a distance from the rotation axis R to the inner surface 30b of the side wall 15b is defined as a radius, the third inner peripheral surface 33b includes a part having a radius greater than a radius of the second inner peripheral surface 32b. Further, the second inner peripheral surface 32b includes a part having a radius greater than a radius of the first inner peripheral surface 31b.

When the vessel 10b rotates about the rotation axis R, molten metal 20 spreads to the second inner peripheral surface 32b by a centrifugal force. Then, the molten metal 20 touches the second inner peripheral surface 32b and the third inner peripheral surface 33b. In the inner surface 30b, the second inner peripheral surface 32b and the third inner peripheral surface 33b are parts that the molten metal 20 touches. The first inner peripheral surface 31b is a part that the molten metal 20 does not touch. Therefore, the molten metal 20 is located between an upper end of the second inner peripheral surface 32b and a lower end of the third inner peripheral surface 33b.

A processed part 40 is formed on the second inner peripheral surface 32b. The processed part 40 may be formed on the third inner peripheral surface 33b. The processed part 40 is not formed on the first inner peripheral surface 31b. Therefore, the processed part 40 may be located between the upper end of the second inner peripheral surface 32b and a lower end of the second inner peripheral surface 32b, or may be located between the upper end of the second inner peripheral surface 32b and the lower end of the third inner peripheral surface 33b.

Next, effects of this embodiment will be described. The light source device 1 according to this embodiment includes a processed part 40 including at least one of a convex part 41 and a concave part 42 provided on an inner surface 30 of a vessel 10. The processed part 40 inhibits surface vibrations of molten metal 20, and stabilizes the position of the surface of the molten metal 20. Accordingly, positional fluctuations of a plasma 21 can be inhibited and a distribution of intensity of EUV light LE retrieved from the light source device 1 can be made uniform.

The processed part 40 may be, for example, a punch mark. Accordingly, there is no need to add any new material, whereby it is possible to maintain the balance of the vessel 10.

The processed part 40 may have a shape extended in the direction of the rotation axis R. With this structure, the flow of the molten metal 20 can be efficiently inhibited. Further, a plurality of processed parts 40 may be disposed at equal intervals in a rotation direction of the rotation axis R. It is therefore possible to maintain the weight balance of the vessel 10. The inner surface of the side wall 15 has a concave part. It becomes therefore easy to collect and maintain the molten metal 20. It is further possible to reduce the amount of the molten metal 20.

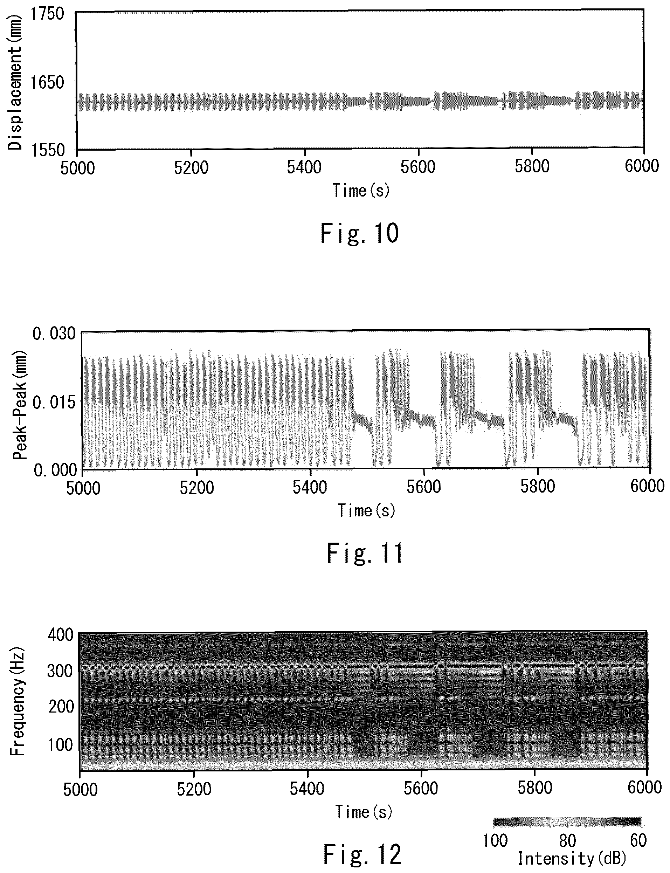

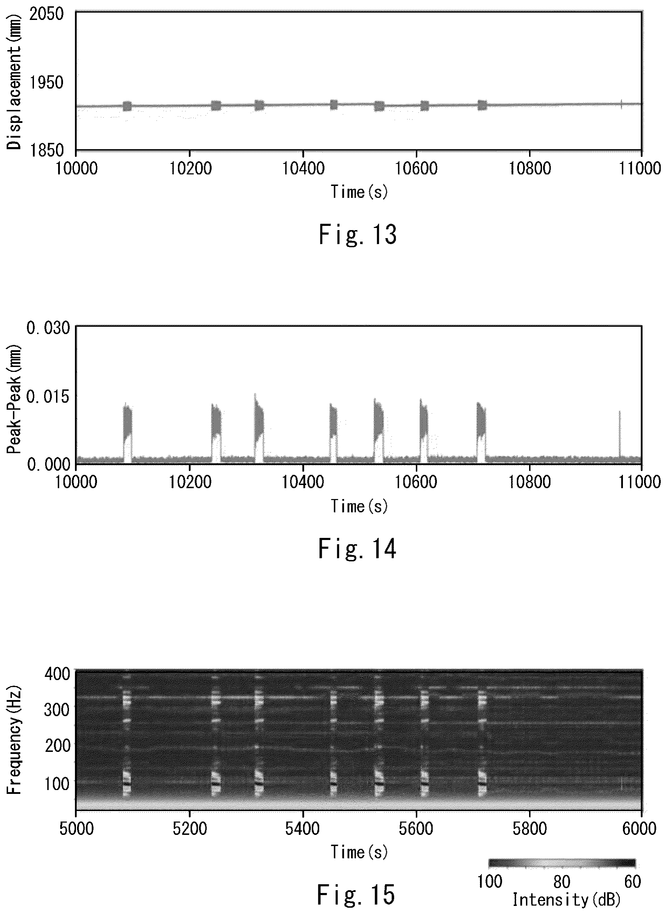

Figs. 10-12 are graphs illustrating behavior of surface vibrations of molten metal 20 in a light source device according to a comparative example. Fig. 10 shows a displacement of a surface of the molten metal 20 with respect to time, Fig. 11 shows a peak-to-peak magnitude of the surface of the molten metal 20 with respect to time, and Fig. 12 shows a vibration frequency of the surface of the molten metal 20 with respect to time. Figs. 13-15 are graphs illustrating behavior of surface vibrations of the molten metal 20 in the light source device 1 according to the first embodiment. Fig. 13 shows a displacement of the surface of the molten metal 20 with respect to time, Fig. 14 shows a peak-to-peak magnitude of the surface of the molten metal 20 with respect to time, and Fig. 15 shows a vibration frequency of the surface of the molten metal 20 with respect to time.

As shown in Figs. 10-12, in the light source device according to the comparative example in which a processed part 40 is not formed on the inner surface 30 of the vessel 10, each of the displacement, the peak-to-peak magnitude of the displacement, and the vibration frequency of the surface of the molten metal 20 is large. These values are due to surface vibrations of the molten metal 20. On the other hand, as shown in Figs. 13-15, in the light source device 1 in which the processed part 40 is formed on the inner surface 30 of the vessel 10, each of the displacement, the peak-to-peak magnitude, and the vibration frequency of the surface of the molten metal 20 is reduced.

Like in the light source device 1 according to this embodiment, the processed part 40 formed on the inner surface 30 of the vessel 10 can inhibit surface vibrations of the molten metal 20 and stabilize the position of the surface of the molten metal 20. Accordingly, the positional fluctuations of the plasma 21 can be inhibited and a distribution of the intensity of the EUV light LE retrieved from the light source device 1 can be made uniform.

Next, surface vibrations of the molten metal 20 are analyzed. Fig. 16 is a diagram illustrating an image obtained by detecting, by a detector, EUV light LE generated by the light source device according to the comparative example. The image shown in Fig. 16 is the one detected by using, for example, Time Delay Integration (TDI) as the detector, in which the horizontal axis indicates a position irradiated with the EUV light LE and the vertical axis indicates time.

As shown in Fig. 16, the detector observes changes in the intensity of three cycles shown by arrows. The intensity of the EUV light LE in each of the arrowed parts is decreased. Therefore, the luminance in each of these parts is decreased. For example, when the position of the surface of the molten metal 20 is displaced in a radius direction centered on the rotation axis R, the focus of the laser light LR is deviated, and the intensity of the EUV light LE is changed. The frequency at which the intensity of the EUV light LE fluctuates is, for example, 310 Hz. On the other hand, the rotational frequency of the vessel 10 such as a crucible is, for example, 330 Hz. Therefore, as shown in Fig. 17, while the vessel 10 makes one turn, the position of the surface of the molten metal 20 fluctuates for one cycle.

The waves of the molten metal 20 are calculated by equations of hydrodynamics as shown in the following Expressions (1) and (2).

[Expression 1]

$$\frac{\partial \rho}{\partial t} + \nabla \cdot (\rho v) = 0 \tag{1}$$

[Expression 2]

$$w = |k| \sqrt{\left(\frac{g}{k} + \frac{\sigma k}{\rho}\right) \tanh kh} \tag{2}$$

Long waves of the molten metal 20 move in the vessel 10 at a frequency 20 Hz slower than that of the rotation of the vessel 10. The long waves satisfy the wavelength (1/k) >> h. Short waves of the molten metal 20 (high k wave, short wavelength ripple) rapidly spread and decay. Therefore, a short wave due to a shot of the previous laser light LR rapidly leaves an area irradiated with the laser light LR. Therefore, short waves do not affect the surface of the shot of the next laser light LR. Due to this reason, in order to make the EUV light LE uniform, long waves need to be inhibited.

Since the processed part 40 according to this embodiment includes a function of reflecting the surface waves of the molten metal 20, the surface waves including the long waves of the molten metal 20 can be reduced and the surface vibrations can be inhibited. Accordingly, the processed part 40 can reduce the luminance fluctuation of about 300 Hz.

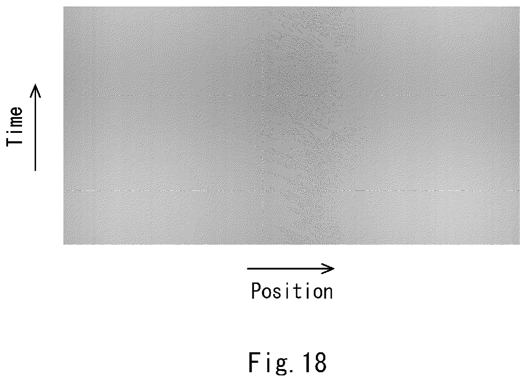

Fig. 18 is a diagram illustrating an image obtained by detecting, by a detector, the EUV light LE generated by the light source device 1 according to the first embodiment. As shown in Fig. 18, the light source device 1 according to this embodiment can reduce a luminance fluctuation of 300 Hz due to surface vibrations observed in the comparative example.

Next, a case where both a flat period in which a luminance fluctuation is reduced due to inhibition of surface vibrations of the molten metal 20 and a fluctuation period in which the luminance fluctuates are included will be described. Even when the processed part 40 is formed on the inner surface 30 of the vessel 10, the flat period and the fluctuation period may be both included depending on the conditions of the vessel 10 and the molten metal 20.

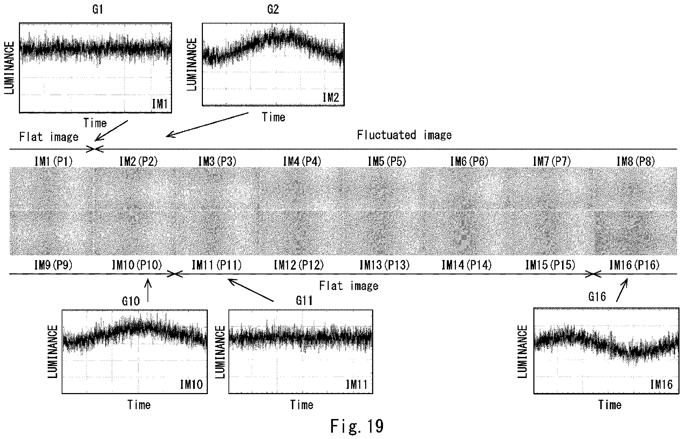

Fig. 19 is a diagram illustrating an image obtained by detecting, by a detector, the EUV light LE generated by the light source device 1 according to the first embodiment. Fig. 19 shows images IM1-IM16 obtained by detecting the EUV light LE by the detector in respective detection periods P1-P16. In the images IM1-IM16, the horizontal axis indicates a position illuminated by the EUV light LE and the vertical axis indicates time.

The images IM1 and IM11-IM15 are flat images detected in the flat period in which the fluctuation of the luminance in each detection period is reduced. The images IM2-IM10 and IM16 are fluctuated images detected in the fluctuation period in which the luminance in each detection period fluctuates.

Fig. 19 also shows graphs G1, G2, G10, G11, and G16 in which the horizontal axis indicates time in the detection period and the vertical axis indicates luminance for the images IM1, IM2, IM10, IM11, and IM16. As shown in the graphs G1 and G11 in Fig. 19, in each of the flat images, the fluctuation of the luminance is reduced. On the other hand, as shown in the graphs G2, G10, and G16, in each of the fluctuated images, the luminance fluctuates.

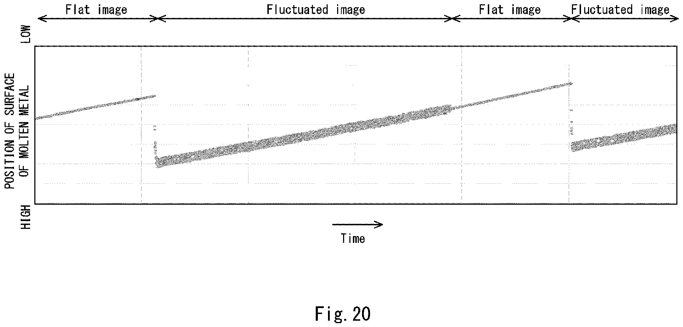

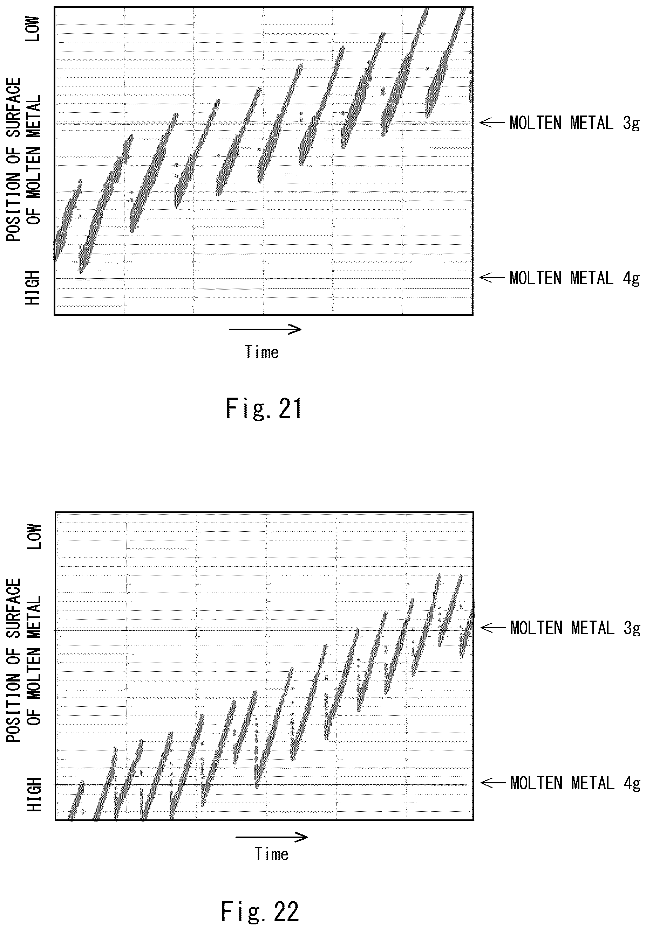

Fig. 20 is a graph illustrating the position of the surface of the molten metal 20 in the vessel 10 in the light source device 1 according to the first embodiment, in which the horizontal axis indicates time and the vertical axis indicates the position of the surface of the molten metal 20. Fig. 22 shows that the height from the inner surface 30 decreases toward the upper side of the vertical axis and the height from the inner surface 30 increases toward the lower side of the vertical axis. That is, the thickness of the molten metal 20 on the inner surface 30 is smaller on the upper side of the graph and the thickness of the molten metal 20 on the inner surface 30 is greater on the lower side of the graph.

As shown in Fig. 20, the molten metal 20 decreases over time, and the position of the surface comes closer to the inner surface 30. The molten metal 20 is replenished for each predetermined period. When the position of the surface of the molten metal 20 is higher than a predetermined position, surface vibrations are large. Therefore, the displacement of the surface of the molten metal 20 is large. In this case, the detector detects a fluctuated image.

On the other hand, when the position of the surface of the molten metal 20 is equal to or lower than the predetermined position, surface vibrations are small. Therefore, the displacement of the surface of the molten metal 20 is small. In this case, the detector detects a flat image. In this manner, the effect of inhibiting the surface vibrations by the processed part 40 may emerge when the position of the surface is equal to or lower than the predetermined position.

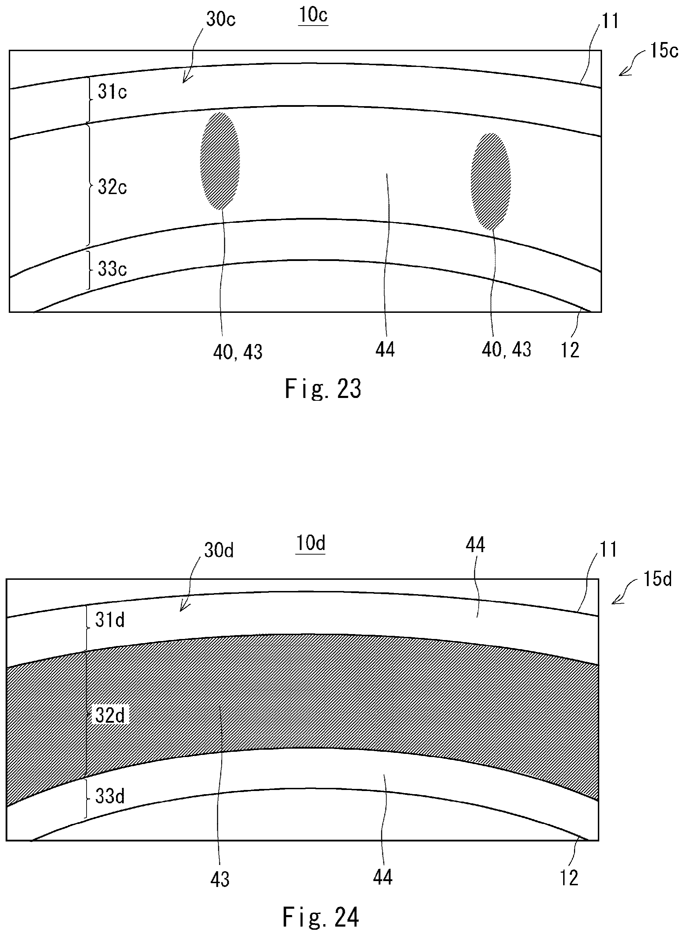

Fig. 21 is a graph illustrating the position of the surface of the molten metal 20 in the vessel 10 in the light source device 1 according to the comparative example, in which the horizontal axis indicates time and the vertical axis indicates the position of the surface of the molten metal 20. Fig. 23 shows that the height from the inner surface 30 decreases toward the upper side of the vertical axis and the height from the inner surface 30 increases toward the lower side of the vertical axis. The processed part 40 is not formed in the vessel according to the comparative example.

As shown in Fig. 21, the molten metal 20 decreases over time, and the position of the surface comes closer to the inner surface 30. For example, the molten metal 20 is replenished for each predetermined period of about 40 minutes. When the position of the surface of the molten metal 20 is higher than a predetermined position, surface vibrations are large. Therefore, the displacement of the surface of the molten metal 20 is large. For example, the displacement width is 10 $\mu$m. In this case, the detector detects a fluctuated image.

On the other hand, when the position of the surface of the molten metal 20 is equal to or lower than the predetermined position, surface vibrations are small. Therefore, the displacement of the surface of the molten metal 20 is small. For example, the displacement width is 1 $\mu$m. In this case, the detector detects a flat image.

Fig. 22 is a graph illustrating the position of the surface of the molten metal 20 in the vessel 10 in the light source device 1 according to the first embodiment, in which the horizontal axis indicates time and the vertical axis indicates the position of the surface of the molten metal 20. Fig. 24 shows that the height from the inner surface 30 decreases toward the upper side of the vertical axis and the height from the inner surface 30 increases toward the lower side of the vertical axis. The vessel 10 according to this embodiment includes a processed part 40.

As shown in Fig. 22, the molten metal 20 decreases over time, and the position of the surface comes closer to the inner surface 30. For example, the molten metal 20 is replenished for each predetermined period of about 35 minutes.

When the position of the surface of the molten metal 20 is higher than a predetermined position, surface vibrations are large. Therefore, the displacement of the surface of the molten metal 20 is large. For example, the displacement width is 10 $\mu$m. In this case, the detector detects a fluctuated image.

On the other hand, when the position of the surface of the molten metal 20 is equal to or lower than the predetermined position, surface vibrations are small. Therefore, the displacement of the surface of the molten metal 20 is small. For example, the displacement width is 1 $\mu$m. In this case, the detector detects a flat image.

As described above, in both the comparative example and the first embodiment, a flat period and a fluctuation period are included. However, in the first embodiment, the amount of the molten metal 20 at which the flat period appears can be made greater than that in the comparative example. For example, a flat period appears when the molten metal 20 is decreased to about 3 grams in the comparative example, whereas a flat period appears when the molten metal 20 is decreased to about 3.5 grams in the first embodiment. Accordingly, in the first embodiment, replenishment intervals can be extended. Further, the amount of fluctuation in the fluctuation period according to the first embodiment can be made smaller than the amount of fluctuation in the fluctuation period according to the comparative example.

(Second Embodiment)

Next, a light source device according to a second embodiment will be described. The light source device according to this embodiment includes a rough surface area on an inner surface 30 of a side wall 15 of a vessel 10. Figs. 23 and 24 are schematic views illustrating an inner surface of a vessel of the light source device according to the second embodiment.

As shown in Fig. 23, in a vessel 10c according to this embodiment, a second inner peripheral surface 32c in an inner surface 30c of a side wall 15c includes a processed part 40. The processed part 40 includes a plurality of convex parts 41, a plurality of concave parts 42, and a rough surface area 43 including one of the plurality of convex parts 41 or the plurality of concave parts 42. A part of the second inner peripheral surface 32c other than the rough surface area 43 may include a smooth surface area 44. The smooth surface area 44 has a surface roughness smaller than a surface roughness of the rough surface area 43. That is, the smooth surface area 44 is a surface smoother than the rough surface area 43. The rough surface area 43 has a surface rougher than the smooth surface area 44.

The parameter indicating the surface roughness may be measured using a desired scale. A first inner peripheral surface 31c and a third inner peripheral surface 33c may each include a smooth surface area 44. Therefore, the inner surface 30c according to this embodiment includes the rough surface area 43 and the smooth surface area 44. The second inner peripheral surface 32c includes the rough surface area 43 and the smooth surface area 44.

As shown in Fig. 24, in a vessel 10d, a second inner peripheral surface 32d on an inner surface 30d of a side wall 15d may include a rough surface area 43, and a first inner peripheral surface 31c and a third inner peripheral surface 33c may each include a smooth surface area 44. That is, the rough surface area 43 may be formed between an upper end of the second inner peripheral surface 32d and a lower end of the second inner peripheral surface 32d. With the aforementioned structure, it is possible to inhibit vibrations of the surface of molten metal 20 and make a distribution of intensity of the EUV light LE uniform.

While the embodiments of the present disclosure have been described above, the present disclosure includes appropriate modifications that do not impar its objects and advantages, and is not limited by the above-described embodiments. Further, the outline of the embodiments and configurations in the first embodiment may be appropriately combined.

This application is based upon and claims the benefit of priority from Japanese patent application No. 2023-015043, filed on February 3, 2023, the disclosure of which is incorporated herein in its entirety by reference.

**Reference Signs List**

1 Light Source Device

10, 10a, 10b, 10c, 10d Vessel

11 Upper End

12 Lower End

13 Bottom Part

14 Bottom Surface

15, 15a, 15b, 15c, 15d Side Wall

16 Heater

17 Collector Mirror

18 Lens

19 Inspection Device

20 Molten Metal

21 Plasma

30, 30a, 30b, 30c, 30d Inner Surface

31, 31a, 31b, 31c, 31d First Inner Peripheral Surface

32, 32a, 32b, 32c, 32d Second Inner Peripheral Surface

33, 33a, 33b, 33c, 33d Third Inner Peripheral Surface

40 Processed Part

41 Convex Part

42 Concave Part

43 Rough Surface Area

44 Smooth Surface Area

LE EUV Light

LR Laser Light

LS Excitation Laser

R Rotation Axis

**Claims**

1. A light source device comprising:

   a vessel having a rotation axis and including a cylindrical side wall that rotates about the rotation axis;
   molten metal that touches at least a part of an inner surface of the side wall; and
   a processed part including at least one of a convex part and a concave part formed in the part,
   wherein the molten metal irradiated by laser light generates light including EUV light.

2. The light source device according to claim 1, wherein

   the inner surface includes a part concave in a direction away from the rotation axis, and
   the processed part is formed in the concave part.

3. The light source device according to claim 1, wherein

the inner surface includes a cylindrical first inner peripheral surface, a cylindrical second inner peripheral surface, and a cylindrical third inner peripheral surface in this order from one end side to another end side along a direction of the rotation axis, and
when a distance from the rotation axis to the inner surface is defined as a radius,
the second inner peripheral surface includes a part having the radius greater than the radius of the first inner peripheral surface, and
the processed part is formed on the second inner peripheral surface.

4. The light source device according to claim 3, wherein

the second inner peripheral surface includes a part having the radius greater than the radius of the third inner peripheral surface, and
the molten metal is located between one end of the second inner peripheral surface and another end of the second inner peripheral surface.

5. The light source device according to claim 1, wherein the processed part extends in a direction of the rotation axis.

6. The light source device according to claim 1, wherein

a plurality of the processed parts are formed in the part, and
the plurality of processed parts are disposed at equal intervals in a rotation direction of the rotation axis.

7. The light source device according to claim 1, wherein the processed part includes the convex part and the concave part formed so as to be adjacent to the convex part.

8. The light source device according to claim 1, wherein the processed part includes a punch mark.

9. The light source device according to claim 1, wherein

the processed part includes a plurality of the convex parts, a plurality of the concave parts, and a rough surface area including one of the plurality of convex parts or the plurality of concave parts, and
the inner surface includes the rough surface area and a smooth surface area having a surface roughness smaller than a surface roughness of the rough surface area.

10. The light source device according to claim 3, wherein

the processed part includes a plurality of the convex parts, a plurality of the concave parts, and a rough surface area including one of the plurality of convex parts or the plurality of concave parts,
the second inner peripheral surface includes the rough surface area, and
at least one of the first inner peripheral surface and the third inner peripheral surface includes a smooth surface area having a surface roughness smaller than a surface roughness of the rough surface area.

<u>1</u>

Fig. 1

Fig. 2

Fig. 3

Fig. 4

Fig. 5

Fig. 6

Fig. 7

10a

Fig. 8

10b

Fig. 9

Fig. 10

Fig. 11

Fig. 12

Fig. 13

Fig. 14

Fig. 15

Fig. 16

Fig. 17

Time

Position

Fig. 18

Fig. 19

Fig. 20

Fig. 21

Fig. 22

Fig. 23

Fig. 24

## INTERNATIONAL SEARCH REPORT

| | International application No. |
|---|---|
| | **PCT/JP2023/045822** |

| A. | CLASSIFICATION OF SUBJECT MATTER |
|---|---|

*G03F 7/20*(2006.01)i
FI: G03F7/20 503

According to International Patent Classification (IPC) or to both national classification and IPC

| B. | FIELDS SEARCHED |
|---|---|

Minimum documentation searched (classification system followed by classification symbols)

G03F7/20: H05G2/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

SPIE Digital Library

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2022-168463 A (LASERTEC CORP.) 08 November 2022 (2022-11-08) paragraphs [0022]-[0027], [0029]-[0032], [0049]-[0050], fig. 1-2, 8 | 1-5 |
| A | | 6-10 |
| A | JP 2007-505460 A (KONINKLIJKE PHILIPS ELECTRONICS N.V., and 1 other) 08 March 2007 (2007-03-08) fig. 1, 7 | 1-10 |
| A | JP 2021-043361 A (LASERTEC CORP.) 18 March 2021 (2021-03-18) fig. 1 | 1-10 |
| A | JP 2007-200919 A (USHIO ELECTRIC INC.) 09 August 2007 (2007-08-09) fig. 1 | 1-10 |
| A | JP 2001-015296 A (SAIFASHA YUGEN) 19 January 2001 (2001-01-19) fig. 1 | 1-10 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 February 2024** | **20 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2023/045822**

| Patent document cited in search report | | | Publication date (day/month/year) | Patent family member(s) | Publication date (day/month/year) |
|---|---|---|---|---|---|
| JP | 2022-168463 | A | 08 November 2022 | (Family: none) | |
| JP | 2007-505460 | A | 08 March 2007 | US 2007/0090304 A1 fig. 1, 7 WO 2005/025280 A2 DE 10342239 A1 CN 1849850 A KR 10-2006-0119962 A TW 200511900 A | |
| JP | 2021-043361 | A | 18 March 2021 | (Family: none) | |
| JP | 2007-200919 | A | 09 August 2007 | (Family: none) | |
| JP | 2001-015296 | A | 19 January 2001 | (Family: none) | |

Form PCT/ISA/210 (patent family annex) (July 2022)

**REFERENCES CITED IN THE DESCRIPTION**

**Patent documents cited in the description**

- JP 2020077007 A
- JP 2015505418 W
- JP 2014216286 A
- JP 2014089880 A
- JP 2023015043 A